# EUROPEAN PATENT APPLICATION

(11) **EP 4 760 297 A1**
(43) Date of publication of application: **17.06.2026**
(21) Application number: 24907921.1
(22) Date of filing: 05.12.2024
(51) Int. Cl.: G01R 31/382, G01R 31/392, G01R 19/165, G01R 31/396, G01R 31/367, G01R 19/30, B60L 58/10

(54) **BATTERY DIAGNOSIS DEVICE AND OPERATING METHOD THEREOF**

(30) Priority: 22.12.2023 KR 20230189924
(71) Applicant: LG Energy Solution, Ltd., Seoul 07335 (KR)
(72) Inventor: LEE, Seul Gi, Daejeon 34122 (KR); KIM, Young Jin, Daejeon 34122 (KR); CHOI, Jee Soon, Daejeon 34122 (KR)
(74) Representative: Plasseraud IP
(86) International application number: PCT/KR2024/019857
(87) International publication number: WO 2025/135637

(57) **Abstract**

A battery diagnosis apparatus according to an embodiment disclosed herein includes an obtaining unit configured to obtain time-series data related to states of a plurality of battery cells included in a battery module, a voltage diagnosing unit configured to calculate a long-short term voltage moving average difference of each battery cell based on the time-series data and diagnose voltage abnormality of each battery cell based on the long-short term voltage moving average difference, a capacity diagnosing unit configured to calculate a state of health (SOH) moving average deviation of each battery cell based on the time-series data and diagnose capacity abnormality of each battery cell based on the SOH moving average deviation, and a detecting unit configured to detect an abnormal battery cell based on a diagnosis result of at least one of the voltage diagnosing unit or the capacity diagnosing unit.

## Description

### TECHNICAL FIELD

### CROSS-REFERENCE TO RELATED APPLICATION

This application claims priority to and the benefit of Korean Patent Application No. 10-2023-0189924 filed in the Korean Intellectual Property Office on December 22, 2023, the entire content of which is incorporated herein by reference.

### TECHNICAL FIELD

Embodiments disclosed herein relate to a battery diagnosis apparatus and an operating method thereof.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery is generally used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

### DISCLOSURE

### TECHNICAL PROBLEM

Meanwhile, when a battery has a defect, the possibility of damage to devices (e.g., an EV, an ESS) including the battery may increase. Accordingly, there is a need for a scheme to reduce the possibility of damage to devices including a battery by detecting an abnormal state of the battery.

Embodiments disclosed herein provide a battery diagnosis apparatus and an operating method thereof in which a state of charge (SOC) balancing window of a battery may be estimated based on battery state data and abnormality of the battery may be diagnosed based on a voltage standard score in the estimated balancing window.

Technical problems of the embodiments disclosed herein are not limited to the aforementioned technical problems, and other unmentioned technical problems would be clearly understood by those of ordinary skill in the art from the following description.

### TECHNICAL SOLUTION

A battery diagnosis apparatus according to an embodiment disclosed herein includes an obtaining unit configured to obtain state data indicating state of charge (SOC) and a voltage standard score (Z-score) of a battery, an estimating unit configured to estimate a first SOC window where balancing of the battery occurs and a second SOC window where balancing does not occur, an extracting unit configured to extract, based on the state data, a first voltage standard score corresponding to the first SOC window and a second voltage standard score corresponding to the second SOC window, and a diagnosing unit configured to diagnose abnormality of the battery based on the first voltage standard score and the second voltage standard score.

In the battery diagnosis apparatus according to an embodiment disclosed herein, the state data may indicate the voltage standard score with respect to the SOC of the battery.

In the battery diagnosis apparatus according to an embodiment disclosed herein, the estimating unit may be further configured to estimate the first SOC window and the second SOC window based on a variance of the voltage standard score with respect to the SOC of the battery.

In the battery diagnosis apparatus according to an embodiment disclosed herein, the first SOC window may include an SOC window where the variance is greater than or equal to a designated value in the state data, and the variance may be less than the designated value in the second SOC window.

In the battery diagnosis apparatus according to an embodiment disclosed herein, the extracting unit may be further configured to extract a maximum voltage standard score of the first SOC window as the first voltage standard score and extract a minimum voltage standard score of the second SOC window as the second voltage standard score.

In the battery diagnosis apparatus according to an embodiment disclosed herein, the diagnosing unit may be further configured to diagnose abnormality of the battery based on a difference between the first voltage standard score and the second voltage standard score.

In the battery diagnosis apparatus according to an embodiment disclosed herein, the diagnosing unit may be further configured to diagnose abnormality of the battery by comparing the difference with a preset threshold value.

In the battery diagnosis apparatus according to an embodiment disclosed herein, the battery diagnosis apparatus may further include an abnormality processing unit configured to perform an abnormality processing function based on an abnormality diagnosis result of the battery, in which the abnormality processing function includes a notification function or a short-circuit function.

An operating method of a battery diagnosis apparatus, according to an embodiment disclosed herein includes obtaining state data indicating state of charge (SOC) and a voltage standard score (Z-score) of a battery, estimating a first SOC window where balancing of the battery occurs and a second SOC window where balancing does not occur, extracting, based on the state data, a first voltage standard score corresponding to the first SOC window and a second voltage standard score corresponding to the second SOC window, and diagnosing abnormality of the battery based on the first voltage standard score and the second voltage standard score.

In the operating method of the battery diagnosis apparatus according to an embodiment disclosed herein, the state data may indicate the voltage standard score with respect to the SOC of the battery.

In the operating method of the battery diagnosis apparatus according to an embodiment disclosed herein, the estimating of the first SOC window and the second SOC window may include estimating the first SOC window and the second SOC window based on a variance of the voltage standard score with respect to the SOC of the battery.

In the operating method of the battery diagnosis apparatus according to an embodiment disclosed herein, the first SOC window may include an SOC window where the variance is greater than or equal to a designated value in the state data, and the variance may be less than the designated value in the second SOC window.

In the operating method of the battery diagnosis apparatus according to an embodiment disclosed herein, the extracting of the first voltage standard score and the second voltage standard score may include extracting a maximum voltage standard score of the first SOC window as the first voltage standard score and extracting a minimum voltage standard score of the second SOC window as the second voltage standard score.

In the operating method of the battery diagnosis apparatus according to an embodiment disclosed herein, the diagnosing of abnormality of the battery may include diagnosing abnormality of the battery based on a difference between the first voltage standard score and the second voltage standard score.

In the operating method of the battery diagnosis apparatus according to an embodiment disclosed herein, the diagnosing of abnormality of the battery may include diagnosing abnormality of the battery by comparing the difference with a preset threshold value.

### ADVANTAGEOUS EFFECTS

According to embodiments disclosed herein, a balancing window may be estimated based on voltage information of a battery without information about battery balancing (e.g., a balancing current, an operating time, etc.).

According to embodiments disclosed herein, the accuracy of diagnosis may be improved by diagnosing abnormality of the battery using a voltage standard score of a battery in the estimated balancing window.

In addition, various effects identified directly or indirectly through this document may be provided.

### DESCRIPTION OF DRAWINGS

FIG. 1 is a block diagram of a battery diagnosis apparatus according to an embodiment.
FIG. 2 is a graph showing state data of a battery, obtained by a battery diagnosis apparatus according to an embodiment.
FIG. 3 is an operating flowchart of a battery diagnosis apparatus according to an embodiment; and
FIG. 4 is an operating flowchart of a battery diagnosis apparatus according to an embodiment.

### MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element).

According to various embodiments, each of the above-described components (e.g., a module or program) may include a single entity or a plurality of entities, some of which may be separately disposed on other components. According to various embodiments, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

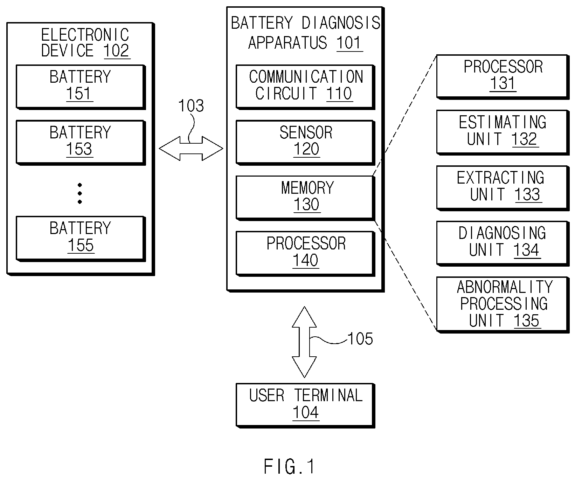

FIG. 1 is a block diagram of a battery diagnosis apparatus according to an embodiment.

The battery diagnosis apparatus 101 described below may be implemented as a battery management system (BMS) in an electronic device 102, and may also be implemented with various external devices such as a server, a cloud, a charger, a charger/discharger, etc.

Referring to FIG. 1, the battery diagnosis apparatus 101 may be wiredly and/or wirelessly connected to an electronic device 102 and a user terminal 104.

According to an embodiment, connection 103 between the battery diagnosis apparatus 101 and the electronic device 102 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

According to another embodiment, the connection 103 between the battery diagnosis apparatus 101 and the electronic device 102 may be connection using a device-to-device communication scheme (e.g., a bus, a general-purpose input and output (GPIO), a serial peripheral interface (SPI), or a mobile industry processor interface (MIPI)).

According to an embodiment, the electronic device 102 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

According to an embodiment, the electronic device 102 may include a plurality of batteries 151, 153, and 155. According to an embodiment, the plurality of batteries 151, 153, and 155 may include at least one of a battery cell, a battery module, a battery pack, or a battery rack.

According to an embodiment, connection 105 between the battery diagnosis apparatus 101 and the user terminal 104 may be communication connection through a wired and/or wireless network.

According to an embodiment, the user terminal 104 may be a mobile device (e.g., a mobile phone, a laptop computer, a smart phone, a smart pad), or a personal computer (PC). According to an embodiment, the battery diagnosis apparatus 101 may provide information related to a diagnosis result of the battery unit 151, 153, or 155 to the user terminal 104.

According to an embodiment, the battery diagnosis apparatus 101 may include a communication circuit 110, a sensor 120, a memory 130, and a processor 140. According to an embodiment, the battery diagnosis apparatus 101 shown in FIG. 1 may further include at least one component (e.g., a display, an input device, or an output device) in addition to the components shown in FIG. 1, or at least one component (e.g., the sensor 120) among the components shown in FIG. 1 may be omitted. For example, when the battery diagnosis apparatus 101 is implemented as a separate external electronic device from the electronic device 102, such as a server, a cloud, etc., the battery diagnosis apparatus 101 may obtain state information of the plurality of batteries 151, 153, and 155 by using the communication circuit 110. In this case, the battery diagnosis apparatus 101 may not include the sensor 120.

According to an embodiment, the communication circuit 110 may establish a wired communication channel and/or a wireless communication channel between the battery diagnosis apparatus 101 and the electronic device 102 and/or the user terminal 104, and transmit and receive data to and from the electronic device 102 and/or the user terminal 104 through the established communication channel.

According to an embodiment, the sensor 120 may measure information (e.g., voltage, current, temperature, etc.,) related to states of the batteries 151, 153, and 155 of the electronic device 102. For example, when the battery diagnosis apparatus 101 is implemented as a BMS in the electronic device, the battery diagnosis apparatus 101 may directly measure states of the plurality of batteries 151, 153, and 155.

According to an embodiment, the communication circuit 110 and/or the sensor 120 may obtain time-series data related to the states of the batteries 151, 153, and 155. In an embodiment, the time-series data related to the states of the plurality of batteries 151, 153, and 155 may include data indicating voltages, currents, resistances, states of charge (SOC), states of health (SOH), and/or temperatures with respect to time.

According to an embodiment, the memory 130 may include a volatile and/or a nonvolatile memory.

According to an embodiment, the memory 130 may store data used by at least one component (e.g., the processor 140) of the battery diagnosis apparatus 101. For example, the data may include software (or an instruction related thereto), input data, or output data. In an embodiment, the instruction, when executed by the processor 140, may cause the battery abnormality diagnosis apparatus 101 to perform operations defined by the instruction.

According to an embodiment, the memory 130 may include one or more software (e.g., an obtaining unit 131, an estimating unit 132, an extracting unit 133, a diagnosing unit 134, and an abnormality processing unit 135).

According to an embodiment, the processor 140 may include a central processing unit, an application processor, a graphic processing unit, a neural processing unit (NPU), an image signal processor, a sensor hub processor, or a communication processor.

According to an embodiment, the processor 140 may execute software (e.g., the obtaining unit 131, the estimating unit 132, the extracting unit 133, the diagnosing unit 134, and the abnormality processing unit 135) stored in the memory 130 to control at least one other component (e.g., a hardware or software component) of the battery diagnosis apparatus 101 connected to the processor 140 and perform various data processing or operations.

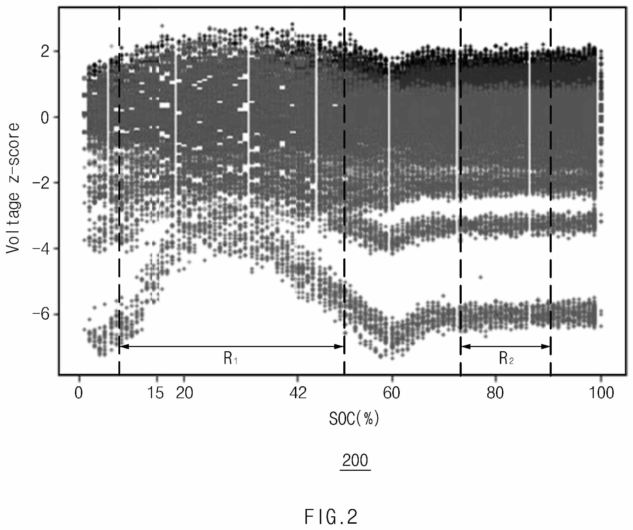

Hereinbelow, referring to FIG. 2, a description will be made of a method, performed by the battery diagnosis apparatus 101, of diagnosing abnormality of the plurality of batteries 151, 153, and 155 through the obtaining unit 131, the estimating unit 132, the extracting unit 133, the diagnosing unit 134, and the abnormality processing unit 135.

FIG. 2 is a graph showing state data of a battery, obtained by a battery diagnosis apparatus according to an embodiment.

According to an embodiment, the obtaining unit 131 may obtain state data indicating SOC and a voltage standard score (Z-score) of the battery 151, 153, or 155. Herein, the state data may indicate the voltage standard score with respect to the SOC of the battery 151, 153, or 155. In other words, the voltage standard score at a specific SOC of the battery 151, 153, or 155 may be known through the state data.

According to an embodiment, the obtaining unit 131 may obtain the state data generated by an external electronic device by using the communication circuit 110.

According to an embodiment, the obtaining unit 131 may obtain the state data based on a state value of the battery, collected using the communication circuit 110 and/or the sensor 120.

According to an embodiment, the obtaining unit 131 may collect a signal related to states of the plurality of batteries 151, 153, and 155 by using the communication circuit 110 and/or the sensor 120 every unit time and record state values (e.g., a voltage value, a current value, a temperature value, a resistance value, SOC, etc.) of the plurality of batteries 151, 153, and 155 in the memory 130. Herein, a unit time may be an integer multiple of a state signal reception period of the communication circuit 110 or a state measurement period of the sensor 120.

According to an embodiment, the obtaining unit 131 may generate state data indicating a voltage standard score with respect to SOC of the battery 151, 153, or 155 based on the state values of the plurality of batteries 151, 153, or 155 recorded in the memory 130. For example, the obtaining unit 131 may calculate the voltage standard score of the battery 151, 153, or 155 based on the voltage values of the plurality of batteries 151, 153, and 155 and then generate the state data. In this case, each time when the state values of the plurality of batteries 151, 153, and 155 are obtained, the number of state data may increase by 1.

Referring to FIG. 2, a graph 200 is shown which indicates voltage data indicating voltage standard scores with respect to SOC of the plurality of batteries (e.g., 151, 153, and 155), obtained by the obtaining unit 131. In the graph 200, a horizontal axis indicates SOC (%) and a vertical axis indicates a voltage standard score.

According to an embodiment, the estimating unit 132 may estimate, based on the state data, a first SOC window where balancing of the battery 151, 153, or 155 occurs and a second SOC window where balancing does not occur. Herein, balancing may mean balancing performed in the battery 151, 153, and/or 155 or performed by the electronic device 102 on the battery 151, 153, and/or 155 to balance voltages or SOC of the plurality of batteries 151, 153, and 155.

According to an embodiment, the estimating unit 132 may estimate the first SOC window and the second SOC window based on a variance of the voltage standard score with respect to the SOC of the battery 151, 153, or 155. Herein, the first SOC window may include an SOC window where the variance is greater than or equal to a designated value in the state data, and the variance may be less than the designated value in the second SOC window.

Referring to the graph 200, the estimating unit 132 may estimate, as the first SOC window, a first window R1 including an SOC window where the variance of the voltage standard score with respect to SOC change is greater than or equal to a designated value (e.g., 3). The estimating unit 132 may estimate, as the second SOC window, a second window R2 where the variance of the voltage standard score with respect to the SOC change is less than the designated value.

According to an embodiment, the extracting unit 133 may estimate a first voltage standard score and a second voltage standard score of the battery 151, 153, or 155 based on the state data. Herein, the first voltage standard score may correspond to the first SOC window estimated by the estimating unit 132, and the second voltage standard score may correspond to the second SOC window estimated by the estimating unit 132. Specifically, the first voltage standard score may be a representative voltage standard score of the first SOC window, and the second voltage standard score may be a representative voltage standard score of the second SOC window.

According to an embodiment, the extracting unit 133 may extract, as the first voltage standard score, a maximum voltage standard score of the battery 151, 153, or 155 in the first SOC window. The extracting unit 133 may also extract, as the second voltage standard score, a minimum voltage standard score of the battery 151, 153, or 155 in the second SOC window. For example, referring to the graph 200, the extracting unit 133 may extract a maximum voltage standard score of the first window R1 as a first voltage standard score and extract a minimum voltage standard score of the second window R2 as a second voltage standard score.

According to an embodiment, the diagnosing unit 134 may diagnose abnormality of the battery 151, 153, or 155 based on the first voltage standard score and the second voltage standard score extracted by the extracting unit 133. According to another embodiment, when the plurality of batteries 151, 153, and 155 are battery cells included in one battery pack, the diagnosing unit 134 may diagnose abnormality of the battery pack including the plurality of batteries 151, 153, and 155 based on the first voltage standard score and the second voltage standard score.

According to an embodiment, the diagnosing unit 134 may calculate a difference between the first voltage standard score and the second voltage standard score. The diagnosing unit 134 may diagnose abnormality of the battery 151, 153, or 155 or the battery pack based on the calculated difference. Herein, the difference may be a value obtained by subtracting the less value from the greater value between the first voltage standard score and the second voltage standard score.

According to an embodiment, the diagnosing unit 134 may compare the difference with a preset threshold value. Herein, the preset threshold value may be set variously according to specifications of the battery 151, 153, or 155. The diagnosing unit 134 may diagnose abnormality of the battery 151, 153, or 155 or the battery pack based on a comparison result.

According to an embodiment, the abnormality processing unit 135 may perform an abnormality processing function based on an abnormality diagnosis result for the battery 151, 153, or 155. Herein, the abnormality processing function may include a notification function or a short-circuit function.

According to an embodiment, the abnormality processing unit 135 may transmit the abnormality diagnosis results for the battery 151, 153, or 155 to the user terminal 104 connected through a wired and/or wireless network.

According to an embodiment, the abnormality processing unit 135 may isolate an abnormal battery from the electronic device 102 based on the abnormality diagnosis result for the battery 151, 153, or 155. Herein, isolation may include electrical and/or mechanical isolation.

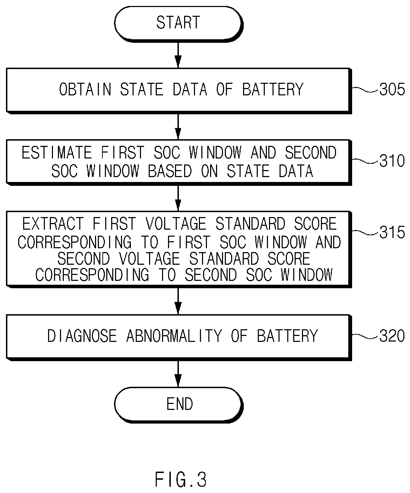

FIG. 3 is an operating flowchart of a battery diagnosis apparatus according to an embodiment. FIG. 3 will be described using the components of FIG. 1.

An embodiment shown in FIG. 3 is merely an embodiment, and an order of operations according to various embodiments of the present disclosure may be different from that shown in FIG. 3, some operations shown in FIG. 3 may be omitted, or an order of the operations may be changed or operations may be merged.

Referring to FIG. 3, in operation 305, the battery diagnosis apparatus 101 may obtain state data indicating SOC and a voltage standard score (Z-score) of the battery 151, 153, or 155. Herein, the state data may indicate the voltage standard score with respect to the SOC of the battery 151, 153, or 155. In other words, the voltage standard score at a specific SOC of the battery 151, 153, or 155 may be known through the state data.

According to an embodiment, the battery diagnosis apparatus 101 may obtain the state data generated by an external electronic device by using the communication circuit 110.

According to an embodiment, the battery diagnosis apparatus 101 may obtain the state data based on a state value of the battery, collected using the communication circuit 110 and/or the sensor 120.

According to an embodiment, the battery diagnosis apparatus 101 may collect a signal related to states of the plurality of batteries 151, 153, and 155 by using the communication circuit 110 and/or the sensor 120 every unit time and record state values (e.g., a voltage value, a current value, a temperature value, a resistance value, SOC, etc.) of the plurality of batteries 151, 153, and 155 in the memory 130. Herein, a unit time may be an integer multiple of a state signal reception period of the communication circuit 110 or a state measurement period of the sensor 120.

According to an embodiment, the battery diagnosis apparatus 101 may generate state data indicating a voltage standard score with respect to SOC of the battery 151, 153, or 155 based on the state values of the plurality of batteries 151, 153, or 155 recorded in the memory 130. For example, the battery diagnosis apparatus 101 may calculate the voltage standard score of the battery 151, 153, or 155 based on the voltage values of the plurality of batteries 151, 153, and 155 and then generate the state data. In this case, each time when the state values of the plurality of batteries 151, 153, and 155 are obtained, the number of state data may increase by 1.

In operation 310, the battery diagnosis apparatus 101 may estimate, based on the state data obtained in operation 305, a first SOC window where balancing of the battery 151, 153, or 155 occurs and a second SOC window where balancing does not occur. Herein, balancing may mean balancing performed in the battery 151, 153, and/or 155 or performed by the electronic device 102 on the battery 151, 153, and/or 155 to balance voltages or SOC of the plurality of batteries 151, 153, and 155.

According to an embodiment, the battery diagnosis apparatus 101 may estimate the first SOC window and the second SOC window based on a variance of the voltage standard score with respect to the SOC of the battery 151, 153, or 155. Herein, the first SOC window may include an SOC window where the variance is greater than or equal to a designated value in the state data, and the variance may be less than the designated value in the second SOC window.

In operation 315, the battery diagnosis apparatus 101 may extract a first voltage standard score and a second voltage standard score of the battery 151, 153, or 155 based on the state data. Herein, the first voltage standard score may correspond to the first SOC window estimated in operation 310, and the second voltage standard score may correspond to the second SOC window estimated in operation 310. Specifically, the first voltage standard score may be a representative voltage standard score of the first SOC window, and the second voltage standard score may be a representative voltage standard score of the second SOC window.

According to an embodiment, the battery diagnosis apparatus 101 may extract, as the first voltage standard score, a maximum voltage standard score of the battery 151, 153, or 155 in the first SOC window. The battery diagnosis apparatus 101 may also extract, as the second voltage standard score, a minimum voltage standard score of the battery 151, 153, or 155 in the second SOC window.

In operation 320, the battery diagnosis apparatus 101 may diagnose abnormality of the battery 151, 153, or 155 based on the first voltage standard score and the second voltage standard score extracted in operation 315. In another example, when the plurality of batteries 151, 153, and 155 are battery cells included in one battery pack, the battery diagnosis apparatus 101 may diagnose abnormality of the battery pack including the plurality of batteries 151, 153, and 155 based on the first voltage standard score and the second voltage standard score.

According to an embodiment, the battery diagnosis apparatus 101 may diagnose abnormality of the battery 151, 153, or 155 or the battery pack based on the difference between the first voltage standard score and the second voltage standard score.

According to an embodiment, the battery diagnosis apparatus 101 may diagnose abnormality of the battery 151, 153, or 155 or the battery pack by comparing the difference with a preset threshold value.

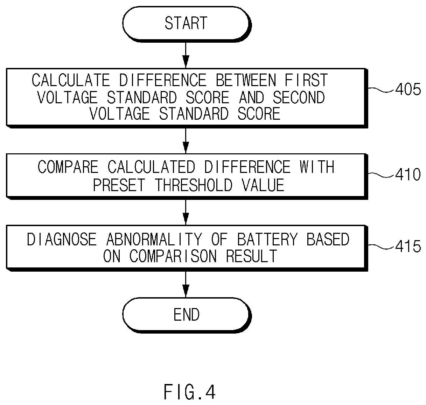

Operation 320, performed by the battery diagnosis apparatus 101, of diagnosing abnormality of the battery cell 151, 153, or 155 or the battery pack will be described in detail with reference to FIG. 4 described below.

FIG. 4 is an operating flowchart of a battery diagnosis apparatus according to an embodiment. FIG. 4 will be described using the components of FIG. 1.

An embodiment shown in FIG. 4 is merely an embodiment, and an order of operations according to various embodiments of the present disclosure may be different from that shown in FIG. 4, some operations shown in FIG. 4 may be omitted, or an order of the operations may be changed or operations may be merged.

Referring to FIG. 4, in operation 405, the battery diagnosis apparatus 101 may calculate the difference between the first voltage standard score and the second voltage standard score. Herein, the difference may be a value obtained by subtracting the less value from the greater value between the first voltage standard score and the second voltage standard score.

In operation 410, the battery diagnosis apparatus 101 may compare the difference calculated in operation 410 with the preset threshold value. Herein, the preset threshold value may be set variously according to specifications of the battery 151, 153, or 155.

In operation 415, the battery diagnosis apparatus 101 may diagnose abnormality of the battery 151, 153, or 155 or the battery pack based on a comparison result of operation 410.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

## Claims

1. A battery diagnosis apparatus comprising:
an obtaining unit configured to obtain state data indicating state of charge (SOC) and a voltage standard score (Z-score) of a battery;
an estimating unit configured to estimate a first SOC window where balancing of the battery occurs and a second SOC window where balancing does not occur;
an extracting unit configured to extract, based on the state data, a first voltage standard score corresponding to the first SOC window and a second voltage standard score corresponding to the second SOC window; and
a diagnosing unit configured to diagnose abnormality of the battery based on the first voltage standard score and the second voltage standard score.

2. The battery diagnosis apparatus of claim 1, wherein the state data indicates the voltage standard score with respect to the SOC of the battery.

3. The battery diagnosis apparatus of claim 2, wherein the estimating unit is further configured to estimate the first SOC window and the second SOC window based on a variance of the voltage standard score with respect to the SOC of the battery.

4. The battery diagnosis apparatus of claim 3, wherein the first SOC window comprises an SOC window where the variance is greater than or equal to a designated value in the state data, and
the variance is less than the designated value in the second SOC window.

5. The battery diagnosis apparatus of claim 1, wherein the extracting unit is further configured to:
extract a maximum voltage standard score of the first SOC window as the first voltage standard score; and
extract a minimum voltage standard score of the second SOC window as the second voltage standard score.

6. The battery diagnosis apparatus of claim 1, wherein the diagnosing unit is further configured to diagnose abnormality of the battery based on a difference between the first voltage standard score and the second voltage standard score.

7. The battery management apparatus of claim 6, wherein the diagnosing unit is further configured to diagnose abnormality of the battery by comparing the difference with a preset threshold value.

8. The battery diagnosis apparatus of claim 1, further comprising an abnormality processing unit configured to perform an abnormality processing function based on an abnormality diagnosis result of the battery,
wherein the abnormality processing function comprises a notification function or a short-circuit function.

9. An operating method of a battery diagnosis apparatus, the operating method comprising:
obtaining state data indicating state of charge (SOC) and a voltage standard score (Z-score) of a battery;
estimating a first SOC window where balancing of the battery occurs and a second SOC window where balancing does not occur;
extracting, based on the state data, a first voltage standard score corresponding to the first SOC window and a second voltage standard score corresponding to the second SOC window; and
diagnosing abnormality of the battery based on the first voltage standard score and the second voltage standard score.

10. The operating method of claim 9, wherein the state data indicates the voltage standard score with respect to the SOC of the battery.

11. The operating method of claim 10, wherein the estimating of the first SOC window and the second SOC window comprises estimating the first SOC window and the second SOC window based on a variance of the voltage standard score with respect to the SOC of the battery.

12. The operating method of claim 11, wherein the first SOC window comprises an SOC window where the variance is greater than or equal to a designated value in the state data, and
the variance is less than the designated value in the second SOC window.

13. The operating method of claim 9, wherein the extracting of the first voltage standard score and the second voltage standard score comprises:
extracting a maximum voltage standard score of the first SOC window as the first voltage standard score; and
extracting a minimum voltage standard score of the second SOC window as the second voltage standard score.

14. The operating method of claim 9, wherein the diagnosing of abnormality of the battery comprises diagnosing abnormality of the battery based on a difference between the first voltage standard score and the second voltage standard score.

15. The operating method of claim 14, wherein the diagnosing of abnormality of the battery comprises diagnosing abnormality of the battery by comparing the difference with a preset threshold value.
